# EUROPEAN PATENT APPLICATION

(11) **EP 4 626 020 A1**
(43) Date of publication of application: **01.10.2025**
(21) Application number: 23944617.2
(22) Date of filing: 10.07.2023
(51) Int. Cl.: H04R 1/10

(54) **ACOUSTIC DEVICE**

(71) Applicant: Shenzhen Shokz Co., Ltd., Shenzhen, Guangdong 518108 (CN)
(72) Inventor: DENG, Wenjun, Shenzhen, Guangdong 518108 (CN); HUANG, Yujia, Shenzhen, Guangdong 518108 (CN); YUAN, Yongshuai, Shenzhen, Guangdong 518108 (CN); LIANG, Xianrong, Shenzhen, Guangdong 518108 (CN); ZHOU, Wenbing, Shenzhen, Guangdong 518108 (CN)
(74) Representative: Wang, Bo
(86) International application number: PCT/CN2023/106612
(87) International publication number: WO 2025/010594

(57) **Abstract**

The present disclosure relates to an acoustic device (100), comprising: a loudspeaker shell (110) including at least one magnetic element; and a magnetic field sensor (121) configured to read a spatial magnetic field. When the spatial magnetic field changes resulting by a change in a relative position of the magnetic element and the magnetic field sensor (121), an output state of the acoustic device (100) changes.

## Description

### TECHNICAL FIELD

The present disclosure relates to the field of acoustic technology, and in particular, to an acoustic device.

### BACKGROUND

In the current market, wear detection sensors are widely used in products such as earphones. A typical application is to automatically wake up the system when the user is detected wearing the earphones and automatically enter standby mode when it detects that the earphones are removed. This achieves the goals of reducing power consumption, extending usage time, simplifying user operations, and significantly enhancing the user experience.

Currently, mainstream wear detection sensors include infrared sensors, capacitive contact sensors, etc. The former suffers from complex structures and systems, while the latter exhibits low stability. Both approaches face issues with insufficient recognition accuracy. Particularly in bone conduction earphones, due to their unique rear-hook wearing style, traditional wear detection solutions cannot achieve ideal detection effects.

Therefore, there is a need to develop an acoustic device and a wear detection scheme to achieve accurate recognition of whether bone conduction earphones are in a wearing state.

### SUMMARY

One of the embodiments of the present disclosure provides an acoustic device. The acoustic device comprises a loudspeaker shell including at least one magnetic element, and a magnetic field sensor configured to read a spatial magnetic field. When the spatial magnetic field changes resulting by a change in a relative position of the magnetic element and the magnetic field sensor, an output state of the acoustic device changes.

In some embodiments, the magnetic field sensor includes at least two magnetic field-sensitive members.

In some embodiments, the at least two magnetic field-sensitive members are arranged in parallel.

In some embodiments, the acoustic device is provided with a mainboard compartment, the mainboard compartment accommodates a circuit mainboard and/or a battery mainboard, and the at least two magnetic field-sensitive members are arranged on the circuit mainboard and/or the battery mainboard, and are located at a side of the circuit mainboard and/or the battery mainboard close to the loudspeaker shell.

In some embodiments, the at least two magnetic field-sensitive members do not overlap with each other.

In some embodiments, a distance between the at least two magnetic field-sensitive members is in a range of 0.1 mm to 20 mm.

In some embodiments, the distance between the at least two magnetic field-sensitive members is in a range of 1 mm to 10 mm.

In some embodiments, the acoustic device is provided with a magnetic suction interface, and a minimum distance between the magnetic suction interface and the at least two magnetic field-sensitive members is greater than or equal to 5 mm.

In some embodiments, the acoustic device further comprises a proximity sensor, the acoustic device is provided with a mainboard compartment, and the proximity sensor is arranged at a side of the loudspeaker shell and/or the mainboard compartment close to a human body.

In some embodiments, the acoustic device comprises an ear hook, and the loudspeaker shell and the magnetic field sensor are connected through the ear hook.

In some embodiments, the loudspeaker shell and the magnetic field sensor are clamped on two sides of an auricle through the ear hook.

In some embodiments, the ear hook includes a first ear hook and a second ear hook, the loudspeaker shell includes a first loudspeaker shell and a second loudspeaker shell, and the acoustic device further comprises a rear hook. The first ear hook is connected to the first loudspeaker shell, the second ear hook is connected to the second loudspeaker shell, and the rear hook is connected to the first ear hook and the second ear hook.

In some embodiments, the acoustic device comprises a control circuit, and the control circuit is configured to control the output state of the acoustic device according to a change in the spatial magnetic field.

In some embodiments, the magnetic field sensor is configured to read a magnetic field strength of the spatial magnetic field along a specific direction, and the control circuit is configured to control the output state of the acoustic device according to the magnetic field strength.

In some embodiments, the control circuit is configured to determine a threshold interval where the magnetic field strength is located, and control the output state of the acoustic device according to the threshold interval of the magnetic field strength.

In some embodiments, the threshold interval includes a first threshold interval and a second threshold interval, when the magnetic field strength is located in the first threshold interval, the acoustic device is in a first output state; and when the magnetic field strength is located in the second threshold interval, the acoustic device is in a second output state.

In some embodiments, the magnetic field sensor includes at least two magnetic field-sensitive members, and the control circuit is configured to perform differential processing on spatial magnetic fields read by the at least two magnetic field-sensitive members and control the output state of the acoustic device according to a differential result.

In some embodiments, the acoustic device further comprises a proximity sensor, and the control circuit is configured to control the output state of the acoustic device according to a detection result of the proximity sensor and the spatial magnetic field read by the magnetic field sensor.

In some embodiments, the magnetic field sensor includes a Hall sensor, an anisotropic magnetoresistance (AMR) sensor, a giant magnetoresistance (GMR) sensor, or a tunnel magnetoresistance (TMR) sensor.

One of the embodiments of the present disclosure further provides an earphone, comprising the acoustic device of any one of embodiments of the present disclosure, and the control circuit is configured to identify a wearing state of the earphone according to the output state of the acoustic device.

### BRIEF DESCRIPTION OF THE DRAWINGS

The present disclosure will be further illustrated by way of exemplary embodiments, which will be described in detail by means of the accompanying drawings. These embodiments are not limiting, and in these embodiments, the same numbering denotes the same structure, where:
FIG. 1 is a schematic diagram illustrating an exemplary acoustic device according to some embodiments of the present disclosure;
FIG. 2 is another schematic diagram illustrating an exemplary acoustic device according to some embodiments of the present disclosure;
FIG. 3 is a schematic diagram illustrating an acoustic device in a second output state according to some embodiments of the present disclosure;
FIG. 4 is another schematic diagram illustrating an acoustic device in a second output state according to some embodiments of the present disclosure;
FIG. 5 is another schematic diagram illustrating an exemplary acoustic device according to some embodiments of the present disclosure;
FIG. 6 is another schematic diagram illustrating an exemplary acoustic device according to some embodiments of the present disclosure;
FIG. 7A is a schematic diagram illustrating a single magnetic field sensor according to some embodiments of the present disclosure;
FIG. 7B is a schematic diagram illustrating two magnetic field sensors according to some embodiments of the present disclosure;
FIG. 8 is a schematic diagram illustrating an exemplary magnetic suction interface according to some embodiments of the present disclosure;
FIG. 9A is a schematic diagram illustrating exemplary positions of two magnetic field-sensitive members according to some embodiments of the present disclosure;
FIG. 9B is a schematic diagram illustrating verification results of two magnetic field-sensitive members according to some embodiments of the present disclosure;
FIG. 10 is a schematic diagram illustrating a proximity sensor in a mainboard compartment according to some embodiments of the present disclosure; and
FIG. 11 is a schematic diagram illustrating a proximity sensor in a loudspeaker compartment according to some embodiments of the present disclosure.

### DETAILED DESCRIPTION

To more clearly illustrate the technical solutions of the embodiments of the present disclosure, the accompanying drawings required to be used in the description of the embodiments are briefly described below. Obviously, the accompanying drawings in the following description are only some examples or embodiments of the present disclosure, and a person of ordinary skill in the art can apply the present disclosure to other similar scenarios in accordance with these drawings without creative labor. Unless obviously obtained from the context or the context illustrates otherwise, the same numeral in the drawings refers to the same structure or operation.

It should be understood that the terms "system," "device," "unit," and/or "module" as used herein is a way to distinguish between different components, elements, parts, sections, or assemblies at different levels. However, the words may be replaced by other expressions if other words accomplish the same purpose.

As shown in the present disclosure and the claims, unless the context suggests an exception, the words "a," "an," "one," "one kind," and/or "the" do not refer specifically to the singular, but may also include the plural. Generally, the terms "including" and "comprising" suggest only the inclusion of clearly identified steps and elements that do not constitute an exclusive list, and the method or apparatus may also include other steps or elements.

Some embodiments of the present disclosure provide an acoustic device. The acoustic device comprises a loudspeaker shell and a magnetic field sensor. The loudspeaker shell includes at least one magnetic element. The magnetic field sensor is configured to read a spatial magnetic field, and when the spatial magnetic field changes resulting by a change in a relative position of the magnetic element and the magnetic field sensor, an output state of the acoustic device changes. The output state of the acoustic device refers to a functional state of the acoustic device. For example, the output state of the acoustic device may include, but is not limited to, playing an audio, pausing the audio, entering a standby mode, turning on the power, turning off the power, or the like.

In the embodiments of the present disclosure, by providing the magnetic field sensor in the acoustic device to read the spatial magnetic field, the output state of the acoustic device is controlled according to a change in the spatial magnetic field read by the magnetic field sensor, which can reduce the power consumption of the acoustic device, extend the usage time of the acoustic device, and improve the interactive experience.

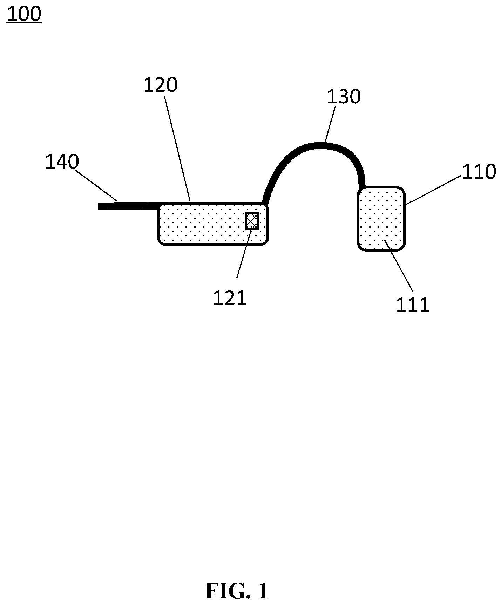

FIG. 1 is a schematic diagram illustrating an acoustic device according to some embodiments of the present disclosure.

In some embodiments, an acoustic device 100 may comprise a loudspeaker shell 110 and a magnetic field sensor 121, as shown in FIG. 1. The loudspeaker shell 110 includes at least one magnetic element and the magnetic field sensor 121 is configured to read a spatial magnetic field.

The loudspeaker shell 110 may be an enclosure structure for accommodating and protecting the magnetic element. In some embodiments, the loudspeaker shell 110 may be shaped as a rectangular, rectangular-like, cylindrical, ellipsoidal, or other regular as well as irregular three-dimensional structure, and the loudspeaker shell 110 may be designed as an integrated (one-piece) or split structure. In some embodiments, the material of the loudspeaker shell 110 may be metal, plastic, ceramic, or the like, so that the loudspeaker shell 110 possesses good strength, wear resistance, and anti-interference performance to effectively protect the electronic components inside (e.g., a magnetic element, a vibration component 111).

In some embodiments, the loudspeaker shell 110 may also be configured to accommodate the vibration component 111. The vibration component 111 may be a loudspeaker in the acoustic device 100 that converts electrical signals into sound. In some embodiments, the type of the vibration component 111 may include dynamic (moving coil), electromagnetic, capacitive, piezoelectric, or the like. Specifically, the dynamic type/dynamic-iron vibration component 111 includes a coil and a permanent magnet that can be used as a magnetic source. When an electric current passes through the coil, the coil interacts with the magnetic field generated by the magnetic source, thereby vibrating the vibration diaphragm to produce sound. The electromagnetic vibration component 111 includes an electromagnetic element that can be used as a magnetic source, and when the electric current is energized, the coil generates a magnetic field that causes the electromagnetic element to attract or repel the vibration diaphragm, thereby causing it to vibrate and emit sound. The capacitive vibration component 111, which does not include a magnetic source, uses two parallel electrode plates to drive the vibration diaphragm, wherein the vibration diaphragm is typically made of an insulating material coated with conductive layers on both sides. When a voltage is applied between the electrodes, the resulting electrostatic force drives the vibration diaphragm to vibrate and produce sound. The piezoelectric vibration component 111, which does not include a magnetic source, utilizes a vibration diaphragm made of piezoelectric ceramic or piezoelectric polymer. When a voltage is applied, the shape of the piezoelectric material is altered to vibrate and produce sound.

The magnetic element may be configured to cooperate with the magnetic field sensor 121 to recognize a change in the relative position of the magnetic element and the magnetic field sensor 121. In some embodiments, the magnetic element may include a magnetic element that is configured to serve as a magnetic source for the vibration component 111. The magnetic source refers to a magnetic element that is capable of generating a spatial magnetic field and is located within the vibration component 111. In some embodiments, the magnetic source includes, but is not limited to, a common magnetic element, an electromagnetic element, a permanent magnet, or the like. For example, if the vibration component 111 is a dynamic type, and the magnetic element may be a permanent magnet. As another example, if the vibration component 111 is an electromagnetic type, and the magnetic element may be an electromagnetic element. In some embodiments, a magnetic field generated by the magnetic element that serves as a magnetic source within the vibration component 111 may be detected by a magnetic field sensor 121, thereby determining a relative position of the magnetic element and the magnetic field sensor 121. In some embodiments, for the piezoelectric vibration component 111, which does not have a magnetic element in its structure, one or more permanent magnets provided separately within the loudspeaker shell 110 may be used as a magnetic source. For the dynamic/dynamic-iron vibration component 111, which has a permanent magnet in its structure, the inherent permanent magnet within the dynamic/dynamic-iron vibration component 111 may be utilized as a magnetic source. It should be noted that there may be one or more magnetic elements within the loudspeaker shell 110. For example, when the vibration component 111 includes a magnetic source, the magnetic element may not be provided within the loudspeaker shell 110, or one or more magnetic elements may be provided within the loudspeaker shell 110. As another example, when the vibration component 111 does not include a magnetic source, at least one magnetic element may be provided within the loudspeaker shell 110.

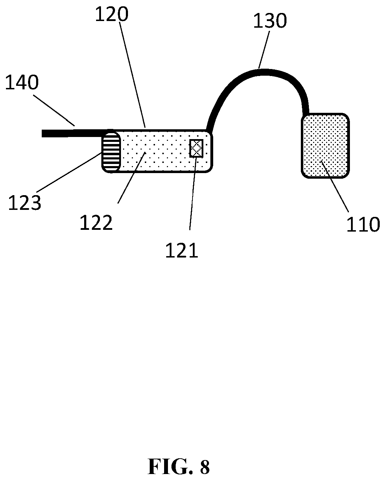

The magnetic field sensor 121 may be configured to read a spatial magnetic field. The spatial magnetic field may be a composite magnetic field formed by the magnetic element of the acoustic device 100 and an external magnetic field. For example, the spatial magnetic field may be a magnetic field formed by a first loudspeaker 111-1, a second loudspeaker 111-2, a magnetic suction interface 123, and the external geomagnetic field, etc. The description of the composite magnetic field can be found in FIG. 8 and the related descriptions thereof. In some embodiments, the magnetic field sensor 121 may read changes in the magnetic field strength in the surrounding space when the magnetic element and the magnetic field sensor 121 are in different relative positions. In some embodiments, the acoustic device 100 may further comprise a control circuit, and the control circuit is capable of controlling the output state of the acoustic device 100 based on the change in the strength of the spatial magnetic field. Specifically, the inherent magnetic element of the vibration component 111 (i.e., a loudspeaker described below) or a separately-provided magnetic element that serves as a magnetic source is used in conjunction with the magnetic field sensor. Changes in the relative positions of the parts of the acoustic device 100 (e.g., the loudspeaker shell 110 and the magnetic field sensor 121) result in changes in the distance and/or angle between the magnetic element within the vibration component 111 and the magnetic field sensor 121, and there is a corresponding change in the strength of the spatial magnetic field detected by the magnetic field sensor 121. The control circuit may control the output state of the acoustic device 100 based on the change in the spatial magnetic field detected by the magnetic field sensor 121. In some embodiments, the changes in the distance and angle between the magnetic source of the acoustic device 100 and the magnetic field sensor 121 result in a change in the spatial magnetic field, which changes a total magnetic field strength or a component magnetic field strength at the magnetic field sensor 121. The control circuit may monitor the change in the magnetic field strength at the magnetic field sensor 121 and control the output state of the acoustic device 100 based on a predetermined threshold interval of magnetic field strength. The description of controlling the output state of the acoustic device 100 according to a threshold interval where the magnetic field strength is located can be referred to herein below, and will not be repeated herein.

In some embodiments, the acoustic device 100 may further comprise an ear hook 130. The ear hook 130 is a member that connects the loudspeaker shell 110 to the magnetic field sensor 121 for securing the acoustic device 100 to a user's ear. In some embodiments, the ear hook 130 may be an arc-shaped structure adapted to the junction between the auricle and the head (T). When the user wears the acoustic device 100, the ear hook is positioned at this junction to keep the acoustic device securely placed on the ear. In this state, the loudspeaker shell 110 and the magnetic field sensor 121 of the acoustic device 100 are located at the front side and the rear side of the auricle, respectively, thereby generating a clamping force on the ear to ensure the stability of the acoustic device 100 during wear. In some embodiments, the ear hook 130 may be made of a more flexible, lightweight, and wear-resistant material such as silicone, soft plastic, titanium alloy, or stainless steel.

In some embodiments, the loudspeaker shell 110 and the magnetic field sensor 121 may be directly connected through the ear hook 130. For example, the magnetic field sensor 121 may be wrapped with a flexible material (e.g., silicone, etc.), and the wrapped magnetic field sensor 121 is directly connected to the loudspeaker shell 110 through the ear hook 130. In some embodiments, the loudspeaker shell 110 and the magnetic field sensor 121 may be indirectly connected through the ear hook 130. For example, the acoustic device 100 may further comprise a functional member shell 120. The magnetic field sensor 121 is disposed within the functional member shell 120, and the magnetic field sensor 121 is connected to the loudspeaker shell 110 through the functional member shell 120 and the ear hook 130. In some embodiments, the functional member shell 120 may also be configured to accommodate other members of the acoustic device 100, for example, a battery, a circuit mainboard, or the like. In some embodiments, the functional member shell 120 may be cylindrical, rectangular, or other customized shapes to meet the needs of the internal component layout. The material of the functional member shell 120 may be ABS plastic, a metal alloy, or other suitable material to ensure lightweight, durability, and comfortable wear.

In some embodiments, the magnetic field sensor 121 may be accommodated within a mainboard compartment or a battery compartment (the mainboard compartment or the battery compartment refers to a compartment formed by the functional member shell 120) of the acoustic device 100. For example, the magnetic field sensor 121 is accommodated in the mainboard compartment, which may be directly mounted on a surface of the mainboard near the vibration component 111, or mounted on a separate PCB or FPC board, and then connected to the mainboard via wires, thereby interfacing with a control chip of the acoustic device. In other embodiments, the magnetic field sensor 121 may also be arranged on the ear hook 130 or a rear hook 140.

In some embodiments of the present disclosure, by accommodating the magnetic field sensor 121 within the mainboard compartment or the battery compartment of the acoustic device 100, additional wires can be avoided, which allows the magnetic field sensor 121 to be positioned closer to the vibration component 111 and helps maintain the overall stability of the acoustic device.

In some embodiments, the magnetic field sensor 121 may include a Hall sensor, an anisotropic magnetoresistance sensor (AMR sensor), a giant magnetoresistance sensor (GMR sensor), or a tunnel magnetoresistance sensor (TMR sensor).

In some embodiments of the present disclosure, by providing the magnetic field sensor 121 in the acoustic device 100 and controlling the output state of the acoustic device 100 based on the spatial magnetic field read by the magnetic field sensor 121, it can reduce the power consumption and extend the usage time of the acoustic device 100.

In addition, the acoustic device 100 described in the embodiments of the present disclosure can be applied to wearable devices such as earphones, hearing aids, glasses, or the like. The control circuit may recognize a wearing state of the wearable device, such as earphones, hearing aids, glasses, or the like, based on the output state of the acoustic device. Taking the application of the acoustic device 100 to an earphone as an example, when the earphone is in a wearing state and a non-wearing state, the relative position between the magnetic element and the magnetic field sensor 121 changes, and the change in the relative position of the two results in a change in the spatial magnetic field, which changes the output state of the acoustic device 100, and the change in the output state can correspond to the change in the wearing state of the earphone. For example, when the earphone is in the non-wearing state, the output state of the acoustic device 100 may be a first output state, and the first output state refers to a function being turned off such as powering off, standby, or stopping playing audio; when the earphone is in the wearing state, the output state of the acoustic device 100 may be a second output state, and the second output state refers to a function enabled state, such as powering on, playing audio.

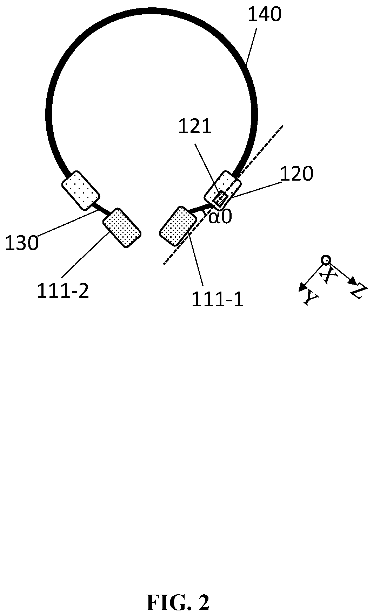

FIG. 2 is another schematic diagram illustrating an acoustic device according to some embodiments of the present disclosure.

As shown in FIG. 2, in some embodiments, the magnetic field sensor 121 reads the magnetic field strength of a spatial magnetic field along a specific direction, and a control circuit controls an output state of the acoustic device 100 based on the magnetic field strength read by the magnetic field sensor 121. The specific direction may include a thickness direction X, a long axis direction Y, and a short axis direction Z. In some embodiments, the X, Y, and Z axes are the three axes of a coordinate system established with the magnetic field sensor 121 itself as the origin. The thickness direction X is parallel to the thickness direction of the magnetic field sensor, and the long axis direction Y and the short axis direction Z are orthogonal to each other. The long axis direction Y is defined as a direction having the largest extended dimension in the shape of the magnetic field sensor 121 (e.g., when the shape of the magnetic field sensor 121 is rectangular or approximately rectangular, the long axis direction is the length direction of the rectangular or approximately rectangular shape), and the short axis direction Z is defined as a direction perpendicular to the long axis direction Y in the shape of the magnetic field sensor 121 (e.g., when the magnetic field sensor 121 is rectangular or approximately rectangular, the short axis direction is the width direction of the rectangular or approximately rectangular shape). It should be noted that the above directions may be any other vector direction under the above coordinate system in addition to the thickness direction X, the long axis direction Y, and the short axis direction Z.

In some embodiments, a magnetic element within the vibration component 111 that serves as a magnetic source is capable of generating a spatial magnetic field, and the position of the magnetic element relative to the magnetic field sensor 121 changes, e.g., if the acoustic device 100 is applied to an earphone, when the earphone switches between a natural state (i.e., the non-wearing state) and the wearing state, it causes a change in the relative position of the magnetic element and the magnetic field sensor 121, and the change in the relative position can result in a change in the spatial magnetic field. In some embodiments, the change in the spatial magnetic field may be a change in a total magnetic field strength, i.e., a change in the vector sum of the respective magnetic field strengths in the thickness direction X, the long axis direction Y, and the short axis direction Z; and the change in the spatial magnetic field may also be a change in a component magnetic field strength, i.e., a change in the magnetic field strength in the thickness direction X, the long axis direction Y, or the short axis direction Z. In some embodiments, a relative distance between the magnetic element within the vibration component 111 that serves as a magnetic source and the magnetic field sensor 121 is relatively fixed, with minimal variation. As a result, the vector sum of the respective magnetic field strengths in the thickness direction X, the long axis direction Y, and the short axis direction Z changes only slightly, and accordingly, the change in the total magnetic field strength is also minimal. Due to angular deflection, a component magnetic field strength along one axis (e.g., the thickness direction X) may increase, while a component magnetic field strength along another axis (e.g., the long axis direction Y or the short axis direction Z) correspondingly decreases. As a result, the change in the component magnetic field strength along the thickness direction X, the long axis direction Y, and the short axis direction Z is greater than the change in the total magnetic field strength. Based on this, the output state of the acoustic device 100 may be controlled by reading the component magnetic field strength in a particular direction by the magnetic field sensor 121.

In some embodiments of the present disclosure, when the position of the magnetic element relative to the magnetic field sensor 121 changes, the change amount of the component magnetic field strength of the spatial magnetic field along a specific direction is relatively large. By controlling the output state of the acoustic device 100 based on the change in magnetic field strength in that specific direction, the accuracy of the output state of the acoustic device 100 can be further improved.

The threshold interval may be a range of values for the magnetic field strength of the magnetic field sensor in a specific direction (or a range of values for a difference between magnetic field strengths of two magnetic field sensors or a difference between two magnetic field-sensitive members in the same direction, as described later), which is used to determine the output state of the acoustic device 100 (e.g., a first output state or a second output state). In some embodiments, the control circuit may determine a threshold interval where the magnetic field strength is located and control the output state of the acoustic device 100 based on the threshold interval where the magnetic field strength is located. In some embodiments, the threshold interval may include a first threshold interval and a second threshold interval. The output state of the acoustic device is different when the magnetic field strength is located in different threshold intervals. The description of the first threshold interval and the second threshold interval can be found below and will not be repeated here.

In some embodiments, when the magnetic field strength is in a different threshold interval, the output state of the acoustic device 100 is different. Threshold intervals are different for different acoustic devices 100, and the threshold intervals may be determined based on factory settings of the acoustic device 100. Specifically, a general threshold interval may be set for the acoustic device 100 during manufacturing. A simple calibration can then be performed for each device using an artificial head to determine its initial factory value. This initial factory value is subsequently used as a reference to define the threshold interval. For example, when the acoustic device 100 is in the first output state (or the acoustic device 100 is applied to an earphone and the earphone is in a non-wearing state), the magnetic field sensor 121 is utilized to measure a magnetic field strength of the acoustic device 100 along a specific direction (e.g., the X-axis, Y-axis, or Z-axis direction) and designate the magnetic field strength as a first initial value. Based on the first initial value, a certain range is defined and expanded to establish the first threshold interval, which serves as a threshold interval corresponding to the magnetic field strength of the acoustic device 100 in the first output state (or when the earphone is in the non-wearing state). When the magnetic field strength is located in the first threshold interval, the output state of the acoustic device 100 may be controlled to be the first output state (or the earphone may be determined to be in the non-wearing state). Similarly, when the acoustic device 100 is in the second output state (or the acoustic device 100 is applied to an earphone and the earphone is in the wearing state), the magnetic field sensor 121 is utilized to measure a magnetic field strength of the acoustic device 100 along a specific direction, and the magnetic field strength is designated as a second initial value. Based on the second initial value, a certain range is defined and expanded to establish the second threshold interval, which serves as a threshold interval corresponding to the magnetic field strength of the acoustic device 100 in the second output state (or when the earphone is in the wearing state). When the magnetic field strength is located in the second threshold interval, the output state of the acoustic device 100 may be controlled to be the second output state (or the earphone may be determined to be in the non-wearing state). The specific direction in the first output state is aligned with the specific direction in the second output state.

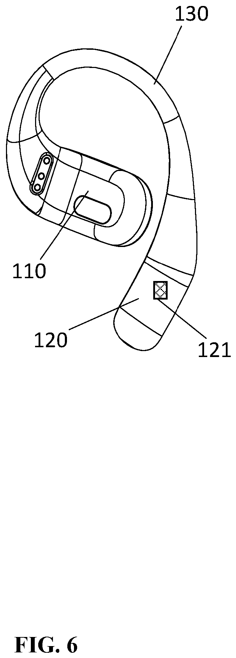

In some embodiments, factors affecting the threshold interval include, but are not limited to, the structure of the acoustic device 100, the type of acoustic device (bone-conducting, air-conducting, bone-air-conducting), the position of the magnetic field sensor 121, a placement manner of the magnetic field sensor 121, or the like. The structure of the acoustic device 100 may include a rear-hanging type, an opening air conduction type (such as a single-ear acoustic device shown in FIG. 6), or the like. The position of the magnetic field sensor 121 may include a position close to or far from a circuit mainboard, a position close to an end of a connection portion between the ear hook 130 and the functional member shell 120, etc. The placement manner of the magnetic field sensor 121 may include a placement manner in which the magnetic field sensor 121 is horizontally placed, vertically placed, or inclinedly placed on the PCB, etc.

Merely by way of example, when the magnetic field sensor 121 is close to the circuit mainboard, the distance and angle between the magnetic element in the vibration component 111 that serves as a magnetic source and the magnetic field sensor 121 changes considerably when the output state of the acoustic device 100 is different (or when the acoustic device 100 is applied to an earphone and the earphone is in the wearing state and the non-wearing state), resulting in the component magnetic field strength in the thickness direction X and the long axis direction Y having a noticeable change. For example, when the output state of the acoustic device 100 is the second output state (or when the earphone is in the wearing state), the component magnetic field strength in the thickness direction X increases and the component magnetic field strength in the long axis direction Y decreases; whereas, when the output state of the acoustic device 100 is the first output state (or when the earphone is in the non-wearing state), the component magnetic field strength in the thickness direction X decreases and the component magnetic field strength in the long axis direction Y increases; and the change in the component magnetic field strength in the short axis direction Z is relatively small.

In some embodiments of the present disclosure, controlling the output state of the acoustic device 100 by determining a threshold interval where the magnetic field strength is located reduces the power consumption and extends the usage time of the acoustic device 100. For example, when the acoustic device 100 is not in use (e.g., the earphone is in the non-wearing state), the output state of the acoustic device 100 may be controlled to be the first output state; when the acoustic device 100 is in use (e.g., the earphone is in the wearing state), the output state of the acoustic device 100 may be controlled to be the second output state.

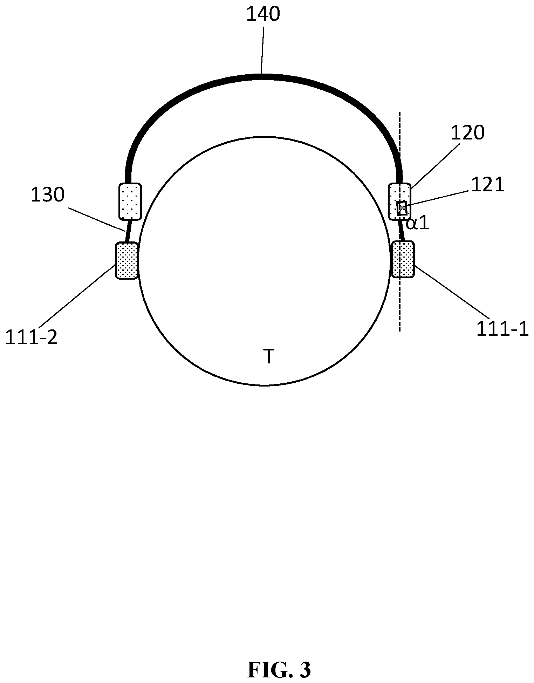

FIG. 3 is a schematic diagram illustrating an acoustic device in a second output state according to some embodiments of the present disclosure.

In some embodiments, a threshold interval includes a first threshold interval and a second threshold interval. When the magnetic field strength is located in the first threshold interval, the acoustic device 100 is in a first output state (when the acoustic device 100 is applied to an earphone, the corresponding earphone is in a non-wearing state). When the magnetic field strength is located in the second threshold interval, the acoustic device 100 is in a second output state (when the acoustic device 100 is applied to an earphone, the corresponding earphone is in a first wearing state, i.e., an over-the-ear state). In some embodiments, there is a boundary between the first threshold interval and the second threshold interval to ensure that an output state of the acoustic device 100 can be accurately controlled (or a wearing state of the earphone can be accurately determined). For example, when a magnetic field strength range corresponding to the first threshold interval is below the boundary, the output state of the acoustic device 100 is the first output state (or representing that the earphone is in the non-wearing state); and when a magnetic field strength range corresponding to the second threshold interval is above the boundary, the output state of the acoustic device 100 is the second output state (or representing that the earphone is in the first wearing state). In some embodiments, a buffer zone (also called a first buffer zone) may be provided between the first threshold interval and the second threshold interval to cope with external magnetic field interference or errors of the magnetic field sensor 121. Merely by way of example, a magnetic field strength of the boundary between the first threshold interval and the second threshold interval is W1, and to cope with the external magnetic field interference or the errors of the magnetic field sensor 121, a magnetic field strength range whose midpoint is the boundary W1 may be set as the first buffer zone, such as [W1-A1, W1+A1], thus when the magnetic field strength is in a magnetic field strength interval of the first buffer zone [W1-A1, W1+A1], a control circuit controls the output state of the acoustic device 100 to be a pending state, rather than precisely controlling the output state of the acoustic device 100 to be the first output state or the second output state.

The first threshold interval refers to a range of values of the magnetic field strength along a specific direction, which corresponds to the acoustic device 100 being in the first output state.

The second threshold interval refers to a range of values for the magnetic field strength along a specific direction, which corresponds to the acoustic device 100 being in the second output state. Referring to FIG. 3, when the acoustic device 100 is in the second output state, it corresponds to the earphone being in the first wearing state. The first wearing state refers to a condition in which the acoustic device 100 or the earphone is worn on the head T, specifically in an over-ear position where the acoustic device is properly placed over the ear.

In some embodiments of the present disclosure, the output state of the acoustic device 100 can be accurately controlled based on different threshold intervals where the magnetic field strength is located.

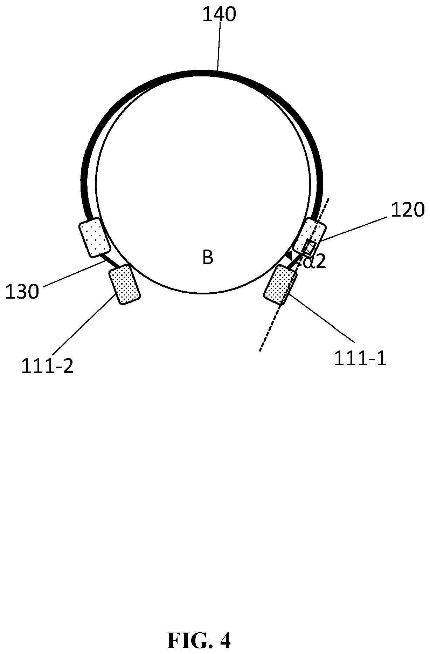

FIG. 4 is another schematic diagram illustrating an acoustic device in a second output state according to some embodiments of the present disclosure.

In some embodiments, the threshold interval may further include a third threshold interval. The third threshold interval refers to a range of values of the magnetic field strength along the specific direction, which corresponds to the acoustic device 100 being in a second output state and an earphone being in a second wearing state when the acoustic device 100 is applied to the earphone. Referring to FIG. 4, the second wearing state refers to a neck-hanging state in which the acoustic device 100 or the earphone is hung around the neck B. That is, when the acoustic device 100 is in the second output state, it corresponds to two wearing states of the earphone, including the first wearing state and the second wearing state. In some embodiments, there is a boundary between the third threshold interval and the second threshold interval to ensure that the two wearing states of the earphone can be accurately distinguished. For example, a magnetic field strength range corresponding to the second threshold interval being below the boundary represents the first wearing state, and a magnetic field strength range corresponding to the third threshold interval being above the boundary represents the second wearing state. In some embodiments, a buffer zone (also called a second buffer zone) may be provided between the third threshold interval and the second threshold interval to cope with external magnetic field interference or errors of the magnetic field sensor 121. Merely by way of example, a magnetic field strength of the boundary between the second threshold interval and the third threshold interval is W2, and to cope with the external magnetic field interference or the errors of the magnetic field sensor 121, a magnetic field strength range whose midpoint is the boundary W2 may be set as the second buffer zone, such as [W2-A2, W2+A2], thus when the magnetic field strength is in a magnetic field strength interval of the second buffer zone [W2-A2, W2+A2], a control circuit controls a wearing state of the earphone to be a pending state, rather than precisely controlling the wearing state of the earphone to be the first wearing state or the second wearing state.

In some embodiments of the present disclosure, effective identification between the neck-hanging state and the ear-hanging state of the earphone can be realized by setting the third threshold interval.

In some embodiments, the acoustic device 100 may include a first loudspeaker 111-1 and a second loudspeaker 111-2, as illustrated in FIG. 2 and FIG. 3. When a magnetic element is included in the second loudspeaker 111-2, a distance between the second loudspeaker 111-2 and the magnetic field sensor 121 also affects the distribution of the magnetic field. When the magnetic field strength detected by the magnetic field sensor 121 is located in the first threshold interval, i.e., when the acoustic device 100 is in the first output state, at this time, the distance between the first loudspeaker 111-1 and the magnetic field sensor 121 and the distance between the second loudspeaker 111-2 and the magnetic field sensor 121 are both relatively small (generally less than 5 cm), and magnetic induction strengths generated by the first loudspeaker 111-1 and the second loudspeaker 111-2 at the magnetic field sensor 121 are B01 and B02, respectively. When external interference magnetic fields such as the geomagnetic field are ignored, a vector sum of B01 and B02 yields a total magnetic field strength B0, and the total magnetic field strength B0 may be decomposed into three orthogonal component field strengths including B0x, B0y, and B0z, corresponding to the X, Y, and Z axes of the coordinate system of the magnetic field sensor. In some embodiments, when the magnetic field strength detected by the magnetic field sensor 121 is located in the second threshold interval, i.e., the acoustic device 100 is in the second output state, the second loudspeaker 111-2 is far away from the magnetic field sensor 121 (the distance between the second loudspeaker 111-2 and the magnetic field sensor 121 is usually greater than 14 cm), the magnetic induction strengths generated by the first loudspeaker 111-1 and the second loudspeaker 111-2 at the magnetic field sensor 121 change significantly. At this time, a total magnetic field strength B1 is obtained by vector addition of the three orthogonal component magnetic field strengths along the X, Y, and Z axes, with the respective magnetic field components being B1x, B1y, and B1z. By measuring the total magnetic field strength or the component magnetic field strength along each axis, and by setting an appropriate threshold interval, the output state of the acoustic device 100 may be controlled.

Referring to FIG. 2 and FIG. 3, in some embodiments, a first angle is formed between the ear hook 130 and the functional member shell 120, and a value of the first angle corresponding to the first threshold interval is greater than a value of the first angle corresponding to the second threshold interval. The first angle corresponding to the first threshold interval may be the angle between the ear hook 130 and the long axis direction of the functional member shell 120 (the dotted line in FIG. 2) when the magnetic field strength is located in the first threshold interval, i.e., when the output state of the acoustic device 100 is the first output state (corresponding to the earphone being in the non-wearing state); similarly, the first angle corresponding to the second threshold interval may be the angle between the ear hook 130 and the long axis direction of the functional member shell 120 (the dotted line in FIG. 3) when the magnetic field strength is located in the second threshold interval, i.e., when the output state of the acoustic device 100 is the second output state (corresponding to the earphone being in the wearing state). As shown in FIG. 2, when the magnetic field strength detected by the magnetic field sensor 121 is located in the first threshold interval, a spatial angle between the ear hook 130 and the functional member shell 120 may be set to α0; when the magnetic field strength detected by the magnetic field sensor 121 is located in the second threshold interval, there is a certain clamping force between the first loudspeaker 111-1 and the temporal bone, and a certain clamping force between the second loudspeaker 111-2 and the temporal bone, which causes the ear hook 130 to undergo a certain deflection. At this time, the spatial angle between the ear hook 130 and the functional member shell 120 becomes α1, as shown in FIG. 3. Thus, the first angle corresponding to the first threshold interval is greater than the first angle corresponding to the second threshold interval. In some embodiments, the ear hook 130 (i.e., a portion of the ear hook 130 between a connection position between the ear hook 130 and the functional member shell 120 and a connection position between the ear hook 130 and the loudspeaker shell 110) may be approximated as a straight line, so that the angle between the ear hook 130 and the long axis direction of the functional member shell 120 may be measured and determined as the first angle. In other embodiments, an angle between the magnetic element and the magnetic field sensor 121 may be another parameter affecting the magnetic field strength, which directly affects the component magnetic field strength along each axis in the coordinate system of the magnetic field sensor.

In some embodiments, when the output state of the acoustic device 100 is the second output state and the earphone is in the second wearing state as shown in FIG. 4, i.e., the earphone being hung around the neck B, an angle between the ear hook 130 and the functional member shell 120 may be α2. Due to the structural characteristics of the acoustic device 100 or the earphone themselves, it is the functional member shell 120 rather than a loudspeaker (i.e., the vibration component 111) that comes in contact with the neck B), so the positional relationship between the magnetic field sensor 121 and the loudspeaker in the second wearing state is different from the positional relationship between the magnetic field sensor 121 and the loudspeaker in the first wearing state, i.e., the angle α2 is not equal to the angle α1, and at the same time, since the distance between the second loudspeaker 111-2 and the magnetic field sensor 121 is reduced, the magnetic field strengths at the magnetic field sensor 121 are different in the first wearing state and the second wearing state, so that the second wearing state of the earphone can be identified.

It will be appreciated that some deformation may occur when the acoustic device 100 is used for an extended period (stemming from the degree of strain on the titanium wire in the ear hook 130), such deformation may affect the first angle, but the change in the first angle resulting from the deformation is not sufficient to cause a failure of the output state of the acoustic device 100 (or a failure of the identification of the wearing state of the earphone).

In some embodiments of the present disclosure, a change in the first angle between the ear hook 130 and the functional member shell 120 can lead to a change in the magnetic field strength at the magnetic field sensor 121, and the wearing state can be identified by determining the threshold interval where the magnetic field strength is located.

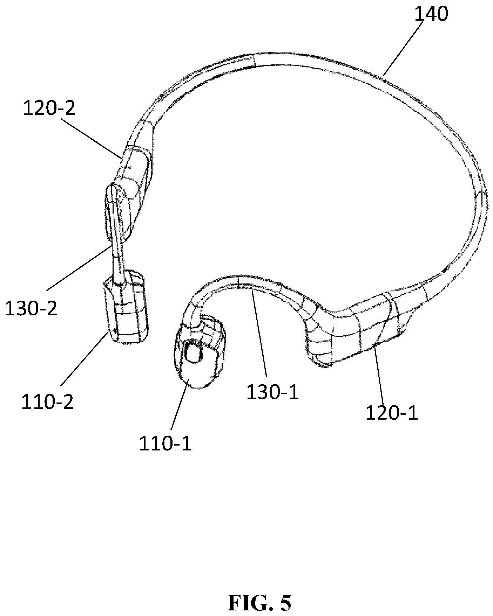

FIG. 5 is another schematic diagram illustrating an acoustic device according to some embodiments of the present disclosure.

As shown in FIG. 5, in some embodiments, the ear hook 130 may include a first ear hook 130-1 and a second ear hook 130-2, and the loudspeaker shell 110 includes a first loudspeaker shell 110-1 and a second loudspeaker shell 110-2. The first ear hook 130-1 is connected to the first loudspeaker shell 110-1, and the second ear hook 130-2 is connected to the second loudspeaker shell 110-2. The acoustic device 100 further comprises the rear hook 140, and the rear hook 140 is connected to the first ear hook 130-1 and the second ear hook 130-2. In some embodiments, the rear hook 140 may be a curved structure that closely conforms to the shape of the user's head T. The rear hook 140 can keep the acoustic device 100 stable on the user's head T and ensure that the ear hook 130 remains snugly fitted against the ear. In some embodiments, the rear hook 140 may be made of plastic, metal, or silicone. In some embodiments, when the user wears the rear-mounted acoustic device 100, it is necessary to place the rear hook 140 behind the head T so that it wraps around the head T and such that the first ear hook 130-1 and the second ear hook 130-2 fit snugly against the junction between the auricle and the head T. In some embodiments, the functional member shell 120 may include a first functional member shell 120-1 and a second functional member shell 120-2. The first loudspeaker shell 110-1 is connected to the first functional member shell 120-1 through the first ear hook 130-1, and the second loudspeaker shell 110-2 is connected to the second functional member shell 120-2 through the second ear hook 130-2.

In some embodiments, a wearing state of the rear-mounted acoustic device may be determined based on a component magnetic field strength.

FIG. 6 is another schematic diagram illustrating an acoustic device according to some embodiments of the present disclosure.

In some embodiments, the loudspeaker shell 110 and the magnetic field sensor 121 (or the functional member shell 120) are clamped to two sides of the ear through the ear hook 130 to keep the acoustic device 100 in place during wear. As shown in FIG. 6, in some embodiments, the ear hook 130 may be a curved structure that closely conforms to the auricle, so that when the user wears the acoustic device 100 as shown in FIG. 6, the ear hook 130 fits snugly against the junction between the auricle and the head T. At this time, the loudspeaker shell 110 and the magnetic field sensor 121 (or the functional member shell 120) are clamped to two sides of the auricle through the ear hook 130 to keep the acoustic device 100 stable during wear. In other embodiments, when the loudspeaker shell 110 and the magnetic field sensor 121 (or the functional member shell 120) are clamped on two sides of the ear through the ear hook 130, the ear hook 130 may also be a clip-on structure, with the loudspeaker shell 110 and the magnetic field sensor 121 positioned at the two ends of the clip, which directly clamps onto two sides of the auricle.

In some embodiments of the present disclosure, a loudspeaker and a mainboard of the acoustic device shown in FIG. 6 may be accommodated in one shell (e.g., the loudspeaker shell 110), and a battery compartment may be accommodated in another shell (e.g., the functional member shell 120). As shown in FIG. 6, the magnetic field sensor 121 is accommodated in the battery compartment, and when the acoustic device 100 is worn, the ear hook 130 undergoes a certain deformation, which leads to a change in a relative position (e.g., an angle) of the loudspeaker and the magnetic field sensor 121, so an output state of the acoustic device can be controlled by measuring a change in a magnetic field by the magnetic field sensor. In some embodiments of the present disclosure, in the acoustic device shown in FIG. 6, the distance between a magnetic element and the magnetic field sensor 121 changes relatively significantly. The resulting change in magnetic field strength caused by distance variations is sufficient to overwhelm interference from the geomagnetic field. Therefore, the acoustic device in FIG. 6 may control the output state of the acoustic device based on either a total magnetic field strength or a component magnetic field strength.

In some embodiments, when the user wears the acoustic device shown in FIG. 6, it is necessary to stretch the ear hook 130 that is connected to the loudspeaker shell 110 and the magnetic field sensor 121 (or the functional member shell 120) on the acoustic device 100 to a certain extent, so that the loudspeaker shell 110 and the magnetic field sensor (or the functional member shell 120) can be separated from each other for a certain distance. The acoustic device 100 is then held securely in place on the auricle through an elastic clamping force of the ear hook 130 on two sides of the ear. In some embodiments, a change in the distance between the magnetic element and the magnetic field sensor 121 causes a change in the total magnetic field strength. The typical value of the geomagnetic field is approximately in a range of 40 VT to 50 VT. To effectively overcome interference from the geomagnetic field, the change in the magnetic field caused by the change in the distance between the magnetic element and the magnetic field sensor 121 must exceed this typical value. Therefore, the change in the distance between the magnetic element and the magnetic field sensor 121 may be greater than 10 mm. It is to be understood that the acoustic device 100 shown in FIG. 6 is small in size, and a certain stretching of the ear hook 130 by the user is sufficient to cause the distance between the magnetic element in the loudspeaker shell 110 and the magnetic field sensor 121 to be significantly changed. At this time, the total magnetic field strength at the magnetic field sensor 121 is correspondingly significantly changed, and thus the output state of the acoustic device 100 can be controlled according to the change in the total magnetic field strength.

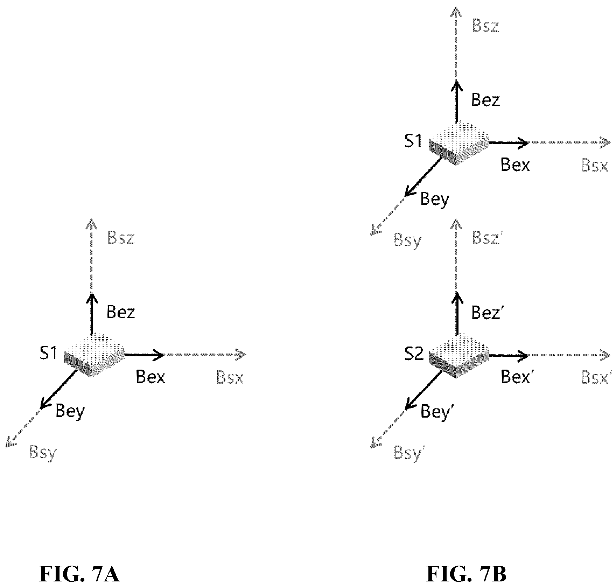

FIG. 7A is a schematic diagram illustrating a single magnetic field sensor according to some embodiments of the present disclosure.

As shown in FIG. 7A, in some embodiments, the acoustic device 100 may detect a change in a spatial magnetic field using a single magnetic field sensor 121, and a magnetic field-sensitive member S1 is arranged within the magnetic field sensor 121. The magnetic field-sensitive member S1 within the magnetic field sensor 121 needs to measure both component magnetic field strengths of the geomagnetic field and a magnetic source (e.g., a permanent magnet within a loudspeaker) within the vibration component 111. A total magnetic field strength component measured by the magnetic field sensor 121 is a vector sum of the component magnetic field strength of the geomagnetic field and the component magnetic field strength of the magnetic source. Specifically, as shown in FIG. 7A, the component magnetic field strengths measured by the magnetic field-sensitive member S1 are denoted as Bx, By, and Bz, where Bx=Bex+Bsx, By=Bey+Bsy, and Bz=Bez+Bsz, where Bex, Bey, and Bez denote the component magnetic field strengths of the geomagnetic field at the magnetic field-sensitive member S1 along the X, Y, and Z axes, respectively, and Bsx, Bsy, and Bsz denote the component magnetic field strengths of the magnetic source within the vibration component 111 at the magnetic field-sensitive member S1 along the X, Y, and Z axes, respectively. As can be seen from FIG. 7A, the geomagnetic field interferes with the component magnetic field strengths (i.e., Bx, By, and Bz) at the single magnetic field-sensitive member S1, which may affect the accuracy and stability of detecting the wearing state of the acoustic device 100.

FIG. 7B is a schematic diagram illustrating two magnetic field sensors according to some embodiments of the present disclosure.

As shown in FIG. 7B, in some embodiments, the acoustic device 100 may detect a change in a spatial magnetic field using two magnetic field sensors 121. The two magnetic field sensors 121 may be two separate magnetic field sensors, or may be two magnetic field-sensitive members (e.g., S1 and S2 as shown in FIG. 7B) within one magnetic field sensor 121. A control circuit may perform a differential processing on spatial magnetic fields read by the two magnetic field-sensitive members S1 and S2, and determine the change in the spatial magnetic field based on a differential result, thereby controlling an output state of the acoustic device 100. Specifically, when the two magnetic field sensors 121 are used, component magnetic field strengths measured at the magnetic field-sensitive member S1 are denoted as Bx, By, and Bz, and component magnetic field strengths measured at the magnetic field-sensitive member S2 are denoted Bx', By', and Bz'. Both sets of component magnetic field strengths are vector sums of component magnetic field strengths of the geomagnetic field and component magnetic field strengths of the magnetic source. Specifically, for the component magnetic field strengths measured at S1: Bx=Bex+Bsx, By=Bey+Bsy, and Bz=Bez+Bsz; and for the component magnetic field strengths measured at S2: Bx'=Bex'+Bsx', By'=Bey'+Bsy', and Bz'=Bez'+Bsz', where Bex', Bey', and Bez' denote the component magnetic field strengths of the geomagnetic field at the magnetic field-sensitive member S2 along the X, Y, and Z axes, respectively, and Bsx', Bsy', and Bsz' denote the component magnetic field strengths of the magnetic source at the magnetic field-sensitive member S2 along the X, Y, and Z axes, respectively. In some embodiments, due to the proximity between the two magnetic field-sensitive members, the geomagnetic field may be approximated as a uniform magnetic field between the two magnetic field-sensitive members, i.e., Bex=Bex', Bey=Bey', Bez=Bez', where, Bex, Bey, and Bez denote the component magnetic field strengths of the geomagnetic field at the magnetic field-sensitive member S1 within the magnetic field sensor 121 along the X, Y, and Z axes, respectively; and Bex', Bey', Bez' denote the component magnetic field strengths of the geomagnetic field at the magnetic field-sensitive member S2 within the magnetic field sensor 121 along the X, Y, and Z axes, respectively. A differential processing is performed on two sets of component magnetic field strengths measured by the two magnetic field-sensitive members, that is, the component magnetic field strengths of Bx', By', and Bz', measured at S2, minus the component magnetic field strengths of Bx, By, and Bz, measured at S1, respectively, i.e., dBx =Bx'-Bx=Bex'+Bsx'-Bex-Bsx=Bsx'-Bsx, dBy=By'-By=Bey'+Bsy'-Bey-Bsy=Bsy'-Bsy, dBz=Bz'-Bz=Bez'+Bsz'-Bez-Bs=Bsz'-Bsz, wherein dBx, dBy, and dBz represent differences in component magnetic field strengths along the X, Y, and Z axes, respectively, at the two magnetic field-sensitive members, obtained by performing the differential processing on the two sets of component magnetic field strengths at the two magnetic field-sensitive members, and dBx, dBy, and dBz represent differences in component magnetic field strengths of an actual spatial magnetic field along the X, Y, and Z axes, respectively, at the two magnetic field-sensitive members. From the foregoing content, it can be seen that an actual magnetic field strength obtained by performing the differential processing on the two sets of component magnetic field strengths measured at the two magnetic field-sensitive members is only related to the component magnetic field strengths of the magnetic source within the acoustic device 100 at the two magnetic field-sensitive members, and is independent of the geomagnetic field or other external magnetic fields.

In some embodiments of the present disclosure, using two or more magnetic field sensors 121 to form an array, or using a single magnetic field sensor 121 including two or more magnetic field-sensitive members can enhance the resistance to interference from external environmental magnetic fields such as the geomagnetic field.

In some embodiments, sensitive axes of the two magnetic field-sensitive members are parallel. The sensitive axis refers to a direction in which the magnetic field-sensitive member is sensitive to a change in a spatial magnetic field, including the thickness direction X, the long axis direction Y, and the short axis direction Z of the magnetic field sensor 121. In some embodiments of the present disclosure, the sensitive axes of the two magnetic field-sensitive members are set to be parallel, so that the two magnetic field-sensitive members have a similar response to the change in the spatial magnetic field along the same direction, which can eliminate the interference of the external magnetic field more efficiently when the differential processing is performed. In other embodiments, the sensitive axes of the two magnetic field-sensitive members may be set at a certain angle (e.g., 45 degrees), so that the two magnetic field-sensitive members may read the spatial magnetic field strengths along different directions, respectively. By calculation, the component magnetic field strengths of the spatial magnetic field along different directions (e.g., the X, Y, and Z axes) may be obtained, and then, the control circuit performs a differential processing on the spatial magnetic fields read by the two magnetic field-sensitive members and control the output state of the acoustic device based on a differential result. It can be understood that, unlike when the sensitive axes of the two magnetic field-sensitive members are set parallel, when the sensitive axes of the two magnetic field-sensitive members are set at an angle, the algorithm of the differential processing needs to be adapted to accommodate the angular difference between the sensitive axes, which can also eliminate the interference of external magnetic fields such as the geomagnetic field and realize the precise control of the output state of acoustic device. In some embodiments of the present disclosure, by setting the sensitive axes of the two magnetic field-sensitive members at a certain angle, it is possible to make the two magnetic field-sensitive members in the magnetic field sensor 121 more flexible.

In some embodiments, the at least two magnetic field-sensitive members may be arranged on a circuit mainboard and/or a battery mainboard and located at a side of the circuit mainboard and/or the battery mainboard close to the loudspeaker shell 110. In other embodiments, the two magnetic field-sensitive members may also be arranged on a flexible printed circuit board (FPC) and connected to the mainboard via wires.

In some embodiments of the present disclosure, by arranging the two magnetic field-sensitive members directly on the circuit mainboard and/or the battery mainboard and at a side of the circuit mainboard and/or the battery mainboard close to the loudspeaker shell 110, the length of wiring required can be reduced, thereby reducing the complexity and the failure rate of the acoustic device.

In some embodiments, the at least two magnetic field-sensitive members do not overlap with each other. For example, the two magnetic field-sensitive members are at different distances from a same magnetic element. The distance between the magnetic field-sensitive member and the magnetic element refers to a distance between a geometric center of the magnetic field-sensitive member and a geometric center of the magnetic element. As another example, the two magnetic field-sensitive members are positioned at different angles relative to the magnetic element. The angle may be represented by an angle between a specific direction (e.g., the thickness direction X, the long axis direction Y, or the short axis direction Z of the magnetic field sensor 121) and a line connecting the magnetic field-sensitive member and the magnetic element (i.e., a line connecting the geometric center of the magnetic field-sensitive member and the geometric center of the magnetic element). In some embodiments, the distance between the two magnetic field-sensitive members is relatively small compared to the scale of the geomagnetic field, so the influence of external magnetic fields, such as the geomagnetic field, is relatively consistent at the two magnetic field-sensitive members and thus has minimal differential impact. In contrast, since the two magnetic field-sensitive members do not overlap with each other, a magnetic field generated by the magnetic element exhibits a noticeable difference in magnetic field strengths at the two magnetic field-sensitive members. Understandably, when the two magnetic field-sensitive members do not overlap with each other, the magnetic field strengths generated by the magnetic element detected by the two magnetic field-sensitive members are different, and such a difference allows for a better differentiation between the change in the magnetic field strength generated by the magnetic element and the interference of external magnetic fields such as the geomagnetic field. In some embodiments of the present disclosure, since the two magnetic field-sensitive members do not overlap each other, the magnetic field generated by the magnetic element has different magnetic field strengths at the two magnetic field-sensitive members, which facilitates the differential processing on the spatial magnetic fields read by the two magnetic field-sensitive members, thereby improving the accuracy of the output state of the acoustic device 100.

In some embodiments, the two magnetic field-sensitive members within the magnetic field sensor 121 not overlapping with each other results in different spatial angles between the sensitive axes of the two magnetic field-sensitive members and vector directions of magnetic field lines generated by the magnetic element passing through the magnetic field sensor 121. These differences can allow the magnetic field sensor 121 to better distinguish between the change in the magnetic field strength at the magnetic field-sensitive member and the interference of external magnetic fields such as the geomagnetic field.

In some embodiments, the distance between the two magnetic field-sensitive members may be in a range of 0.1 mm to 20 mm. In some embodiments, the distance between the two magnetic field-sensitive members may be in a range of 0.1 mm to 10 mm. In some embodiments, the distance between the two magnetic field-sensitive members may be in a range of 1 mm to 10 mm. Preferably, the distance between the two magnetic field-sensitive members may be in a range of 1 mm to 5 mm, and within this range, the spatial change of external magnetic fields, such as the geomagnetic field, is relatively small, and the external magnetic field can be approximated as a uniform magnetic field between the two magnetic field-sensitive members. It can be understood that in the process of performing the differential processing on the spatial magnetic fields read by the two magnetic field-sensitive members, the difference between the magnetic field strengths measured by each of the two magnetic field-sensitive members affects the accuracy of the differential processing. As the geomagnetic field and other external magnetic fields can be approximated as a uniform magnetic field between the two magnetic field-sensitive members, the effect of the geomagnetic field and other external magnetic fields on the two magnetic field-sensitive members can be approximated as the same. As a result, when the differential processing is performed on the spatial magnetic fields read by the two magnetic field-sensitive members, the influence of external magnetic fields, such as the geomagnetic field, is effectively canceled out, thereby highlighting the magnetic field difference generated by the magnetic source of the acoustic device 100. In such cases, the differential processing eliminates interference from the external magnetic fields and improves the accuracy of the output state of the acoustic device 100.

In some embodiments of the present disclosure, by setting the distance between the two magnetic field-sensitive members within a suitable range, it is possible to make the external magnetic fields, such as the geomagnetic field, be approximated as a uniform magnetic field between the two magnetic field-sensitive members, which facilitates the differential processing on the two magnetic field-sensitive members read by the two magnetic field-sensitive members.

FIG. 8 is a schematic diagram illustrating a magnetic suction interface according to some embodiments of the present disclosure.

As shown in FIG. 8, in some embodiments, the acoustic device 100 is provided with a magnetic suction interface 123. The magnetic suction interface 123 is arranged on a circuit mainboard 122 and is on a side of the circuit mainboard 122 that is away from the loudspeaker shell 110, and a minimal distance between the magnetic suction interface 123 and a magnetic field-sensitive member (i.e., the magnetic field sensor 121) is greater than or equal to 5 mm. In some embodiments, the magnetic suction interface 123 may be a magnetic suction charging interface for charging the acoustic device 100. In the embodiments of the present disclosure, an acoustic device 100 may be designed so that the magnetic suction charging interface, i.e., the magnetic suction interface 123, is provided at a tail portion of the circuit mainboard 122 (at a position on the circuit mainboard 122 away from the loudspeaker shell 110). Since the magnetic suction interface 123 includes at least one permanent magnet, which also creates a magnetic field in the surrounding space, therefore, the spatial magnetic field measured by the magnetic field sensor 121 is a composite magnetic field composed of the first loudspeaker 111-1, the second loudspeaker 111-2, the magnetic suction interface 123, and the external geomagnetic field. The position of the magnetic suction interface 123 relative to the magnetic field sensor 121 is fixed, and thus, a magnetic field generated by the magnetic suction interface 123 at the magnetic field sensor 121 is a constant magnetic field, which can be easily eliminated through algorithmic calibration. In some embodiments, when the magnetic field strength generated by the magnetic suction interface 123 at the magnetic field sensor 121 is too large, it can reduce the sensitivity of the magnetic field sensor 121 in recognizing the position of a loudspeaker. Therefore, to reduce the influence of the magnetic suction interface and prevent the magnetic field sensor 121 from exceeding the range, the minimum distance between the magnetic suction interface 123 and the magnetic field sensor 121 may be greater than or equal to 5 mm. In some embodiments, to reduce the influence of the magnetic suction interface and prevent the magnetic field sensor 121 from exceeding the range, the minimum distance between the magnetic suction interface 123 and the magnetic field sensor 121 may be greater than or equal to 8 mm.

In some embodiments of the present disclosure, by providing the magnetic suction interface 123, the acoustic device 100 can be charged conveniently and quickly. By setting a reasonable distance between the magnetic suction interface 123 and the magnetic field-sensitive member, the acoustic device 100 can be charged conveniently and quickly while also reducing the influence of the spatial magnetic field generated by the magnetic suction interface 123 on the magnetic field strength read by the magnetic field sensor 121, thereby improving the sensitivity of the magnetic field sensor 121 in recognizing the position of the magnetic element.

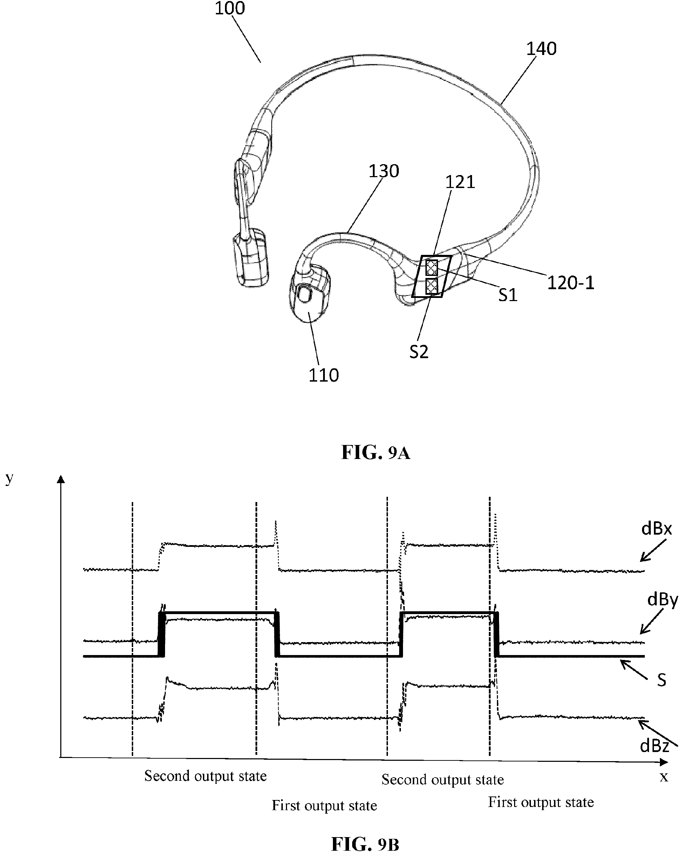

FIG. 9A is a schematic diagram illustrating positions of two magnetic field-sensitive members according to some embodiments of the present disclosure. FIG. 9B is a schematic diagram illustrating verification results of two magnetic field-sensitive members according to some embodiments of the present disclosure.

As shown in FIG. 9A, a spacing L1 between two magnetic field-sensitive members S1 and S2 within the acoustic device 100 is set to 2 mm. Sensitive axes of the two magnetic field-sensitive members S1 and S2 are parallel to each other, and the two magnetic field-sensitive members S1 and S2 are accommodated inside the first functional member shell 120-1 of the acoustic device 100 and close to the loudspeaker, i.e., the loudspeaker shell 110. By performing a differential processing on component magnetic field strengths of each of two magnetic field-sensitive members S1 and S2 (a detailed description of the differential processing can be referred to FIG. 7B and the related descriptions thereof) along three axes, respectively, actual component magnetic field strengths at the magnetic field sensor 121 along the three axes, respectively, may be obtained as dBx, dBy, and dBz. As shown in FIG. 9B, the x-axis represents an output state of the acoustic device 100 (a first output state or a second output state), the y-axis represents the magnitude of the actual component magnetic field strengths dBx, dBy, and dBz at the magnetic field sensor 121 along three axes, respectively, and the curve S is obtained by performing a comprehensive calculation on the component magnetic field strengths dBx, dBy, and dBz along the three axes, e.g., the values on curve S may represent an average value of a sum of dBx, dBy, and dBz. As can be seen from FIG. 9B, the curves of dBx, dBy, dBz are synchronized or approximately synchronized with the change of the curve S. When the curve S (or the curves of dBx, dBy, dBz) is high, the output state of the acoustic device 100 is the second output state (corresponding to the earphone being in the wearing state), and when the curve S (or the curves of dBx, dBy, dBz) is low, the output state of the acoustic device 100 is the first output state (corresponding to the earphone being in the non-wearing state). It will be appreciated that the curves of dBx, dBy, and dBz are all capable of changing significantly and accurately reflecting changes in the output state (or a wearing state of the earphone) of the acoustic device 100, with the judgment process being the same as for curve S. In the embodiments of the present disclosure, during experiments, the behaviors such as walking, jumping, running, shaking, or the like did not affect the determination result of the magnetic field sensor 121, which indicates that a solution using two magnetic field sensors 121 or a single magnetic field sensor 121 including two magnetic field-sensitive members S1 and S2 offers excellent stability and repeatability in detecting the output state of the acoustic device 100, and provides strong resistance to interference from external magnetic fields such as the geomagnetic field.

In some embodiments, the magnetic field sensor 121 may read the total magnetic field strength of the spatial magnetic field and control the output state of the acoustic device 100 based on the total magnetic field strength.

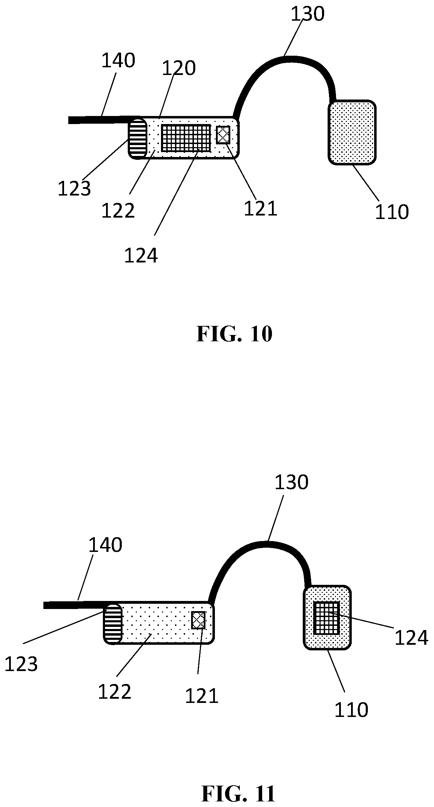

FIG. 10 is a schematic diagram illustrating a proximity sensor accommodated in a mainboard compartment according to some embodiments of the present disclosure. FIG. 11 is a schematic diagram illustrating a proximity sensor accommodated in a loudspeaker compartment according to some embodiments of the present disclosure.

In some embodiments, the acoustic device 100 may further comprise a proximity sensor 124. As shown in FIG. 10, the proximity sensor 124 may be arranged on a side of the mainboard compartment (i.e., a compartment formed by the functional member shell 120) that is close to the human body. As shown in FIG. 11, the proximity sensor 124 is accommodated within the loudspeaker shell 110. In some embodiments, the proximity sensor 124 is configured to detect the proximity of the human skin. When the proximity sensor 124 is close to the human body, a to-be-measured value changes significantly, and when the to-be-measured value reaches a preset threshold, the output state of the acoustic device 100 may be controlled to be the second output state. Taking the application of the acoustic device 100 to an earphone as an example, when a user wears the earphone, the proximity sensor 124 is close to the human skin, and the to-be-measured value changes until it reaches the preset threshold, and at this time, it can control the output state of the acoustic device 100 to be the second output state, and correspondingly, the earphone is in the wearing state. The to-be-measured value refers to a signal value (e.g., a capacitance value, a light intensity, etc.) measured by the proximity sensor 124, which may be used to indicate a distance between the proximity sensor 124 and the human skin, thereby controlling the output state of the acoustic device 100 (or determining whether the earphone is in the wearing state). The preset threshold may be a preset parameter used to control the output state of the acoustic device 100. In some embodiments, the preset threshold may be set based on a signal value measured by the proximity sensor 124. Specifically, the to-be-measured value of the proximity sensor 124 changes significantly when the acoustic device 100 is close to, or in contact with, the user's skin. When the to-be-measured value exceeds or is equal to the preset threshold, it can be considered that the acoustic device 100 is already in the wearing state and the control circuit controls the acoustic device 100 to be in the second output state. When the to-be-measured value does not exceed the preset threshold, it can be considered that the acoustic device 100 is in the non-wearing state, and the control circuit controls the acoustic device 100 to be in the first output state. In some embodiments, the magnetic field sensor 121 and the proximity sensor 124 may be used jointly to control the output state of the acoustic device 100. For example, when the control circuit determines that the magnetic field sensor 121 detects that the component magnetic field strength along each axis is located in a threshold interval, and the to-be-measured value of the proximity sensor 124 reaches the preset threshold, the acoustic device 100 may be controlled to be in the second output state; or, when the control circuit determines that the magnetic field sensor 121 detects that component magnetic field strength along each axis is not located in the threshold interval, and the to-be-measured value of the proximity sensor 124 does not reach the preset threshold, the acoustic device 100 may be controlled to be in the first output state. In some embodiments, the proximity sensor 124 may include, but is not limited to, a capacitive proximity sensor, a photoelectric proximity sensor, or the like.

In some embodiments of the present disclosure, by using various sensors, the accuracy of controlling the output state of the acoustic device 100 can be further improved, thereby reducing the power consumption of the acoustic device 100 and extending its usage time. Additionally, it can simplify user operations, thereby enhancing the overall user experience.

The basic concepts have been described above, and it is apparent to those skilled in the art that the foregoing detailed disclosure serves only as an example and does not constitute a limitation of the present disclosure. While not expressly stated herein, various modifications, improvements, and amendments may be made to this specification by those skilled in the art. Those types of modifications, improvements, and amendments are suggested in the present disclosure, so those types of modifications, improvements, and amendments remain within the spirit and scope of the exemplary embodiments of the present disclosure.

Also, the present disclosure uses specific words to describe embodiments of the present disclosure, such as "an embodiment," "one embodiment," and/or "some embodiments" means a feature, structure, or characteristic associated with at least one embodiment of the present disclosure. Accordingly, it should be emphasized and noted that "one embodiment" or "an embodiment" or "an alternative embodiment" in different places in the present disclosure do not necessarily refer to the same embodiment. In addition, certain features, structures, or characteristics in one or more embodiments of the present disclosure may be suitably combined.

Additionally, unless expressly stated in the claims, the order of the processing elements and sequences, the use of numerical letters, or the use of other names as described in the present disclosure are not intended to qualify the order of the processes and methods of the present disclosure. While some embodiments of the invention that are currently considered useful are discussed in the foregoing disclosure by way of various examples, it should be appreciated that such details serve only illustrative purposes, and that additional claims are not limited to the disclosed embodiments, rather, the claims are intended to cover all amendments and equivalent combinations that are consistent with the substance and scope of the embodiments of the present disclosure. For example, although the implementation of various components described above may be embodied in a hardware device, it may also be implemented as a software only solution, e.g., an installation on an existing server or mobile device.

Similarly, it should be noted that in order to simplify the presentation of the present disclosure, and thereby aid in the understanding of one or more embodiments of the invention, the foregoing descriptions of embodiments of the present disclosure sometimes group multiple features together in a single embodiment, accompanying drawings, or a description thereof. However, this method of disclosure does not imply that the objects of the present disclosure require more features than those mentioned in the claims. Rather, claimed subject matter may lie in less than all features of a single foregoing disclosed embodiment.

Some embodiments use numbers to describe the number of components, attributes, and it should be understood that such numbers used in the description of embodiments are modified in some examples by the modifiers "approximately," "nearly," or "substantially". Unless otherwise noted, the terms "approximately," "nearly," or "substantially" indicates that a ±20% variation in the stated number is allowed. Correspondingly, in some embodiments, the numerical parameters used in the present disclosure and claims are approximations, which can change depending on the desired characteristics of individual embodiments. In some embodiments, the numerical parameters should take into account the specified number of valid digits and employ general place-keeping. While the numerical domains and parameters used to confirm the breadth of their ranges in some embodiments of the present disclosure are approximations, in specific embodiments, such values are set to be as precise as possible within a feasible range.

For each patent, patent application, patent application disclosure, and other material cited in the present disclosure, such as articles, books, manuals, publications, documents, etc., the entire contents of which are hereby incorporated by reference into the present disclosure Application history documents that are inconsistent with or conflict with the contents of the present disclosure are excluded, as are documents (currently or hereafter appended to the present disclosure) that limit the broadest scope of the claims of the present disclosure. It should be noted that in the event of any inconsistency or conflict between the descriptions, definitions, and/or use of terms in the materials appended to the present disclosure and those set forth herein, the descriptions, definitions and/or use of terms in this specification shall prevail.

Finally, it should be understood that the embodiments described in the present disclosure are only used to illustrate the principles of the embodiments of the present disclosure. Other deformations may also fall within the scope of the present disclosure. As such, alternative configurations of embodiments of the present disclosure may be viewed as consistent with the teachings of the present specification as an example, not as a limitation. Correspondingly, the embodiments of the present disclosure are not limited to the embodiments expressly presented and described herein.

## Claims

1. An acoustic device, comprising:
a loudspeaker shell including at least one magnetic element; and
a magnetic field sensor configured to read a spatial magnetic field, wherein
when the spatial magnetic field changes resulting by a change in a relative position of the magnetic element and the magnetic field sensor, an output state of the acoustic device changes.

2. The acoustic device of claim 1, wherein the magnetic field sensor includes at least two magnetic field-sensitive members.

3. The acoustic device of claim 2, wherein the at least two magnetic field-sensitive members are arranged in parallel.

4. The acoustic device of claim 2, wherein the acoustic device is provided with a mainboard compartment, the mainboard compartment accommodates a circuit mainboard and/or a battery mainboard, and the at least two magnetic field-sensitive members are arranged on the circuit mainboard and/or the battery mainboard, and are located at a side of the circuit mainboard and/or the battery mainboard close to the loudspeaker shell.

5. The acoustic device of claim 2, wherein the at least two magnetic field-sensitive members do not overlap with each other.

6. The acoustic device of claim 2, wherein a distance between the at least two magnetic field-sensitive members is in a range of 0.1 mm to 20 mm.

7. The acoustic device of claim 6, wherein the distance between the at least two magnetic field-sensitive members is in a range of 1 mm to 10 mm.

8. The acoustic device of claim 2, wherein the acoustic device is provided with a magnetic suction interface, and a minimum distance between the magnetic suction interface and the at least two magnetic field-sensitive members is greater than or equal to 5 mm.

9. The acoustic device of claim 1, wherein the acoustic device further comprises a proximity sensor, the acoustic device is provided with a mainboard compartment, and the proximity sensor is arranged at a side of the loudspeaker shell and/or the mainboard compartment close to a human body.

10. The acoustic device of claim 1, wherein the acoustic device comprises an ear hook, and the loudspeaker shell and the magnetic field sensor are connected through the ear hook.

11. The acoustic device of claim 10, wherein the loudspeaker shell and the magnetic field sensor are clamped on two sides of an auricle through the ear hook.

12. The acoustic device of claim 10, wherein
the ear hook includes a first ear hook and a second ear hook,
the loudspeaker shell includes a first loudspeaker shell and a second loudspeaker shell, and
the acoustic device further comprises a rear hook, wherein
the first ear hook is connected to the first loudspeaker shell,
the second ear hook is connected to the second loudspeaker shell, and
the rear hook is connected to the first ear hook and the second ear hook.

13. The acoustic device of claim 1, wherein the acoustic device comprises a control circuit, and the control circuit is configured to control the output state of the acoustic device according to a change in the spatial magnetic field.

14. The acoustic device of claim 13, wherein
the magnetic field sensor is configured to read a magnetic field strength of the spatial magnetic field along a specific direction, and
the control circuit is configured to control the output state of the acoustic device according to the magnetic field strength.

15. The acoustic device of claim 14, wherein the control circuit is configured to:
determine a threshold interval where the magnetic field strength is located, and
control the output state of the acoustic device according to the threshold interval of the magnetic field strength.

16. The acoustic device of claim 15, wherein the threshold interval includes a first threshold interval and a second threshold interval,
when the magnetic field strength is located in the first threshold interval, the acoustic device is in a first output state; and
when the magnetic field strength is located in the second threshold interval, the acoustic device is in a second output state.

17. The acoustic device of claim 13, wherein the magnetic field sensor includes at least two magnetic field-sensitive members, and the control circuit is configured to perform differential processing on spatial magnetic fields read by the at least two magnetic field-sensitive members and control the output state of the acoustic device according to a differential result.

18. The acoustic device of claim 13, wherein the acoustic device further comprises a proximity sensor, and the control circuit is configured to control the output state of the acoustic device according to a detection result of the proximity sensor and the spatial magnetic field read by the magnetic field sensor.

19. The acoustic device of any one of claims 1 to 18, wherein the magnetic field sensor includes a Hall sensor, an anisotropic magnetoresistance (AMR) sensor, a giant magnetoresistance (GMR) sensor, or a tunnel magnetoresistance (TMR) sensor.

20. An earphone, comprising the acoustic device of any one of claims 1 to 19, and the control circuit is configured to identify a wearing state of the earphone according to the output state of the acoustic device.
